# EUROPÄISCHE PATENTSCHRIFT

(11) **EP 3 372 059 B1**
(45) Veröffentlichungstag und Bekanntmachung des Hinweises auf die Patenterteilung: **06.05.2020**
(21) Anmeldenummer: 16805289.2
(22) Anmeldetag: 30.11.2016
(51) Int. Cl.: H05K 3/46, H05K 7/18, B33Y 80/00

(54) **SCHALTSCHRANK MIT SCHALTTAFEL SOWIE VERFAHREN ZUR HERSTELLUNG IM 3D-DRUCKVERFAHREN DIESES SCHALTTAFEL**
SWITCHGEAR CABINET COMPRISING A SWITCHBOARD, AND METHOD FOR MANUFACTURING SUCH A SWITCHBOARD IN A 3D PRINTING PROCESS
ARMOIRE ÉLECTRIQUE AVEC TABLEAU DE COMMANDE AINSI QUE LE PROCÉDÉ DE FABRICATION DANS UN PROCÉDÉ D'IMPRESSION 3D DU TABLEAU DE COMMANDE

(30) Priorität: 18.12.2015 DE 102015016505; 22.02.2016 DE 102016002052
(43) Veröffentlichungstag der Anmeldung: 12.09.2018
(73) Patentinhaber: Liebherr-Components Biberach GmbH, 88400 Biberach an der Riß (DE)
(72) Erfinder: FENKER, Oliver, 88447 Warthausen (DE)
(74) Vertreter: Thoma, Michael
(86) Internationale Anmeldenummer: PCT/EP2016/002022
(87) Internationale Veröffentlichungsnummer: WO 2017/102065

(56) Entgegenhaltungen:
- EP-A1- 2 943 048
- WO-A2-2014/209994
- DE-A1-102014 201 121
- DE-A1-102014 209 762
- US-A1- 2013 170 171
- US-A1- 2015 201 499
- US-A1- 2015 235 798
- US-A1- 2015 305 198

## Beschreibung

Die vorliegende Erfindung betrifft allgemein Schaltschränke, die zumindest eine Schalttafel mit zumindest einer Grundplatte umfassen, auf der elektrische Schaltgeräte zum Übertragen und/oder Verteilen elektrischer Energie an zumindest ein Betriebsmittel angeordnet und miteinander elektrisch verbunden sind. Die Erfindung betrifft dabei insbesondere ein Verfahren zur Herstellung eines solchen Schaltschranks.

In der bisherigen Art, Schaltschränke aufzubauen, sind viele manuelle Vorgänge enthalten, beispielsweise das Bohren der Schaltplatte, das Anbringen der elektrischen Bauteile sowie das Verbinden der einzelnen elektrischen Anschlüsse der Bauteile. Diese manuellen Vorgänge sind fehleranfällig und haben hohe Kosten. Zudem ist es in weiten Bereichen üblich, einen Schaltschrank in einem darauf spezialisierten Betrieb zu fertigen und zu montieren und dann weitgehend vormontiert an den Einsatzort zu transportieren, wo dann lediglich noch die externen Aggregate bzw. Betriebsmittel wie beispielsweise die vom Schaltschrank zu steuernden Motoren angeschlossen werden, sowie dies beispielsweise bei Kranen wie Baukranen, Hafen- oder Offshorekranen der Fall ist. Dies verursacht regelmäßig hohe Transportkosten.

Solche Schaltschränke umfassen dabei regelmäßig mehrere Schalttafeln, die liegend und/oder aufrecht in einem Schaltschrankgehäuse untergebracht werden. Dabei sind auf Grundplatten regelmäßig eine Vielzahl von Schaltelementen montiert, die miteinander elektrisch verbunden bzw. verkabelt werden, um die Schaltungslogik zu realisieren. Die genannten Schaltelemente bzw. -geräte können hierbei verschiedenster Art sein, beispielsweise Schalter, Taster, Anzeigeelemente wie Anzeige-Displays oder Anzeigelampen, Messgeräte, Eingabemittel wie Touchscreens, Druckknöpfe, Kippschalter und dergleichen. Insbesondere können auch Bauteile der Leistungselektronik als Schaltelemente an der Grundplatte vorgesehen werden, beispielsweise Frequenzumrichter und Ähnliches. Auch Sicherungen oder Prüfschalter können Teil der Schalttafel sein.

Ein solcher Schaltschrank bildet also bzw. umfasst üblicherweise eine Niederspannungs-Schaltgerätekombination in einem entsprechenden Leergehäuse, wobei die genannte Schaltgerätekombination meistens sowohl einen Steuerungsteil in Form eines Hilfsstromkreises als auch einen Leistungsteil in Form eines Hauptstromkreises inklusive der notwendigen Überwachung wie z.B. Sicherungen umfasst. Ein Schaltschrank enthält somit eine Zusammenfassung eines oder mehrere Niederspannungs-Schaltgeräte mit zugehörigen Betriebsmitteln zum Steuern, Messen, Melden, Schützen und Regeln, mit allen inneren elektrischen und mechanischen Verbindungen und Konstruktionsteilen.

Schaltschränke haben dabei die Aufgabe, im Betrieb elektrische Energie von einem oder mehreren Lieferanten zu erhalten und diese Energie über ein oder mehrere Kabel oder Leitungen an andere Betriebsmittel zu verteilen. Hierbei umfasst der vorgenannte Hauptstromkreis alle leitfähigen Teile einer Schaltgerätekombination in einem Stromkreis, der elektrische Leistung übertragen soll, während der Hilfsstromkreis alle leitfähigen Teile einer Schaltgerätekombination in einem Stromkreis, der nicht der vorgenannte Hauptstromkreis ist und keine elektrische Leistung übertragen soll, für Steuerung, Messung, Meldung, Regelung und Datenverarbeitung umfasst.

Aus den Schriften DE 89 02 022 U1, US 2015/0201499 A1, WO 2014/2009994 A2 und DE 10 2011 100 555 A1, US 2015/305198 A1, DE 10 2014 201 124 A1, US 2013/170171 A1, EP 2 943 048 A1, US 2015/235798 und DE 10 2014 209 762 A1 ist es bekannt, elektronische Baugruppen in Form von Platinen zumindest teilweise mittels 3D-Druck und anderen Beschichtungsmaßnahmen zu fertigen. Dabei zeigt die US 2015/201499 A1 einen Schaltschrank sowie ein Verfahren zu dessen Herstellung nach den Oberbegriffen der Ansprüche 1 und 8. Im Gegensatz zu einem Schaltschrank sind solche Platinen jedoch lediglich Elektronikbaugruppen, die der Informationsverarbeitung und Steuerung dienen, ohne dass hierdurch elektrische Leistung empfangen und auf entsprechende Verbraucher übertragen bzw. verteilt werden würde. Solche Elektronikbaugruppen in Form von Platinen wurden anfangs in analoger Technik gefertigt, was dann schrittweise über die Digitaltechnik bis zur Mikrocontrollertechnik weiterentwickelt wurde.

Im Gegensatz zu Schaltschränken treten bei solchen Platinen und Elektronikbaugruppen sehr viel kleinere Spannungs- und Leistungsbereiche auf. Während bei Platinen und ähnlichen Elektronikbaugruppen für die Informationsverarbeitung und Steuerung Themen wie beispielsweise Berührsicherheit, Stromschläge oder Lichtbogenunfälle aufgrund der bei Elektronikbaugruppen herrschenden kleinen Spannungs- und Leistungsbereichen nahezu nicht relevant sind, sind die genannten Themen im Schaltschrankbau fast immer zu beachten. Aufgrund dieses grundsätzlichen Unterschieds zwischen Platinen und Elektronikbaugruppen für die Informationsverarbeitung und Steuerung einerseits und Schaltschränken zum Verteilen und Übertragen elektrischer Energie auf andere Betriebselemente mit zum Teil lebensgefährlichen Spannungen, Stromschlaggefahr und Lichtbogen-Unfällen andererseits werden für die Fertigung von Schaltschränken besondere Sorgfalts- und Sicherheitsmaßnahmen gefordert, um den besonderen Gefahren eines Schaltschranks zu begegnen. Insbesondere wurden im Schaltschrankbau einzelne Niederspannungsschaltgeräte separat und nacheinander eingebaut und eingesetzt. Zudem wurde eine spezielle Strukturierung des Innenaufbaus mit separaten Montageplatten, Tragschienen sowie eine Unterteilung in Haupt- und Hilfsstromkreis vorgenommen, um den genannten, besonderen Gefahren Rechnung zu tragen. Dies macht die Fertigung jedoch aufwändig und kleinteilig sowie für den Schaltschrankmonteur ermüdend.

Der vorliegenden Erfindung liegt die Aufgabe zugrunde, einen verbesserten Schaltschrank der genannten Art und ein verbessertes Verfahren zu dessen Herstellung anzugeben, die Nachteile des Standes der Technik vermeiden und letzteren in vorteilhafter Weise weiterbilden. Insbesondere soll der Aufwand und die Fehleranfälligkeit beim Fertigen und Montieren des Schaltschranks vermieden und eine dezentrale Fertigung des Schaltschranks ermöglicht werden.

Erfindungsgemäß wird diese Aufgabe durch ein Verfahren gemäß Anspruch 1 sowie einen Schaltschrank gemäß Anspruch 8 gelöst. Bevorzugte Ausgestaltungen der Erfindung sind Gegenstand der abhängigen Ansprüche.

Es wird also vorgeschlagen, den Schaltschrank einschließlich dessen Hauptstromkreis mit seinen elektrischen Komponenten zum Übertragen und/oder Verteilen von elektrischer Energie möglichst weitgehend mit dreidimensionaler Drucktechnik herzustellen. Erfindungsgemäß wird zumindest die Grundplatte mit zumindest einem der auf der Grundplatte angeordneten Schaltelemente zum Übertragen und/oder Verteilen von elektrischer Energie mittels eines 3D-Druckers in einem 3D-Druckverfahren hergestellt. Hierbei können die Grundplatte und das genannte Schaltelement schichtweise aufgebaut werden, wobei mittels eines Energiestrahls Werkstoffschichten nacheinander schichtweise verflüssigt und/oder verfestigt werden können. Beispielsweise können ein oder mehrere Werkstoffe pulverförmig und/oder pastös und/oder flüssig schichtweise aufgetragen und durch einen Laserstrahl oder Elektronenstrahl oder Plasmastrahl entsprechend schichtweise aufgeschmolzen oder verfestigt und/oder ausgehärtet und/oder zur chemischen Reaktion gebracht werden, um jeweils eine ausgehärtete Schicht zu bilden. Überraschenderweise können mittels der 3D-Drucktechnik auch leistungsübertragende Schaltgeräte, mittels derer elektrische Leistung von einem oder mehrern Lieferanten erhalten und auf Abnehmer verteilt wird, ausreichend sicher gefertigt werden, um den besonderen Gefahren bei Schaltschränken wie Stromschlägen, Überhitzungen, Explosionen oder Lichtbogen zu begegnen. Entgegen bisheriger Erwartungen lässt sich auch die Schaltgerätekombination in einem Stromkreis, der elektrische Leistung übertragen soll, mittels einem 3D-Druckverfahren in der benötigten Qualität fertigen.

Durch eine solche Herstellung im 3D-Druckverfahren können die gedruckten Schaltschränke oder Teile davon direkt bzw. nahe am Einsatzort gefertigt werden, wodurch Transportkosten drastisch reduziert werden können, da nicht mehr der ganze Schaltschrank bzw. dessen Grundplatten und/oder Schaltelemente transportiert werden müssen, sondern lediglich noch die für den 3D-Drucker benötigten Fertigungsdaten. Zudem können diverse manuelle Montage- und Fertigungsschritte insbesondere bei der Verkabelung eingespart und hierdurch die zugehörige Fehleranfälligkeit vermieden werden. Zudem ergeben sich deutlich größere Gestaltungsfreiheiten bei der Konzeptionierung und Architektur der Schalttafeln.

Hierdurch ist gemäß der Erfindung eine Schaltlogik in die Grundplatte integriert. Hierdurch kann ein mühsames Verkabeln der an der Grundplatte angebrachten elektrischen Schaltelemente vermieden oder zumindest stark reduziert werden und damit auch die hiermit verbundene Fehleranfälligkeit beseitigt werden. Insbesondere können elektrische Verbindungsleiter zum Verbinden der elektrischen Schaltelemente und -geräte in die Grundplatte integriert werden, wobei die genannte Schaltlogik bzw. die genannten elektrischen Verbindungsleiter mittels des 3D-Druckers gleich beim Ausbilden der Grundplatte mit ausgebildet werden können, sodass die Schaltungslogik und der Korpus der Grundplatte in einem Arbeitsschritt hergestellt werden können. Ferner können auch kleinere Logikbauteile wie Widerstände, Induktivitäten oder Kapazitäten, aber auch elektrische oder mechanische Verbindungen und Strukturteile wie Halter, Führungen oder Positionierer in die Grundplatte integriert und mittels 3D-Druck aufgebaut werden.

Zusätzlich zur integralen Ausbildung der Verbindungsleiter beim 3D-Druck-Prozess sind beim 3D-Drucker der Grundplatte darin auch Kanäle und/oder Anpassungen als Hohlräume ausgebildet, in die dann nachträglich Kabel, Leiter oder andere elektrische Bauteile eingesetzt werden könnten.

Grundsätzlich könnten hierbei nur die Grundplatte und die darin integrierte Schaltungslogik per 3D-Drucker ausgebildet werden, sodass anstelle der bislang üblichen Kabelkanäle fest verdrahtete Grundplatten geschaffen werden, die automatisiert gefertigt werden können und intern Leiterbahnen zur Signalführung aufweisen können. Mit solchen Grundplatten könnten an sich handelsübliche Schaltgeräte verwendet werden, wobei die Anschlüsse der Schaltgeräte mit Leitungen zu den genannten Grundplatten hergestellt werden können. Alternativ können aber auch die Schaltgeräte bzw. Schaltelemente und insbesondere auch leistungsübertragende Bauteile zumindest teilweise per 3D-Druck hergestellt werden, wie noch erläutert wird.

Gemäß der Erfindung ist die Grundplatte als Verbundwerkstoffplatte aus verschiedenen Werkstoffen im 3D-Druckverfahren ausgebildet, wobei hier ein signal- und/oder stromleitendes Material in Form gezielter Strukturen in ein nicht leitendes Matrixmaterial eingebettet ist. Beispielsweise können Kupferstrukturen, die dann als Leiter in der fertigen Grundplatte fungieren, in ein nicht leitendes Matrixmaterial, beispielsweise ein keramisches Material, eingebettet werden, wobei der sich mit der Kupferstruktur bildende Plattenkorpus Schicht für Schicht aufgebaut wird. Hierzu kann beispielsweise in jeder Schicht ein Matrixmaterial pulverförmig verteilt werden, in das an den gewünschten Stellen Kupferpartikel oder ein Kupferpulver eingebracht wird, sodass dann bei der Energiestrahlbehandlung eine Schicht entsteht, in der lokal begrenzt ein Kupferstrukturteil ausgebildet wird, welches sich mit den Kupferstrukturteilen in der darunterliegenden Schicht und in der darüberliegenden, erst noch auszubildenden Schicht, zu einer bspw. leiter- oder strangförmigen Leitstruktur verbindet. '

Der Schaltschrank kann grundsätzlich mehrere miteinander verbundene Grundplatten mit jeweils zumindest einer Schaltgerätekombination aufweisen, wobei die genannten Grundplatten einschließlich ihrer Schaltgerätekombinationen liegend oder aufrecht in dem Schaltschrank verbaut werden können. Anstelle mehrerer Grundplatten kann auch eine große Grundplatte Verwendung finden, auf der dann alle Schaltelemente angeordnet werden.

Werden mehrere Grundplatten verwendet, die bspw. jeweils einen senkrechten oder waagerechten Platz für einen Kabelkanal bilden können, können die Grundplatten vorteilhafter Weise Klemmen oder andere Elemente zur elektrischen Verbindung besitzen, mittels derer die Grundplatten miteinander verbunden werden können, wobei die genannten elektrischen Anschlüsse insbesondere Signal- und/oder Stromleitungsanschlüsse umfassen können. Vorteilhafterweise können die genannten elektrischen Verbindungsabschnitte der Grundplatte mittels dreidimensionaler Drucktechnik ausgebildet werden, wobei es jedoch auch möglich wäre, die genannten elektrischen Anschlüsse nachträglich in anderer Weise an den durch 3D-Druck ausgebildeten Platten anzubringen. Die genannten elektrischen Verbindungsabschnitte an den Grundplatten sind zueinander passend bzw. komplementär zueinander ausgebildet, bspw. in Form männlicher und weiblicher Konnektoren, sodass die Grundplatten bei einer Schaltschrankmontage an den elektrischen Verbindungsabschnitten zusammengefügt werden können.

Elektrische Verbindungen wie z. B. Steck- oder Klemmenverbindungen werden auch zwischen der Grundplatte und den daran anzuordnenden Schaltelementen vorgesehen, derart, dass an der Grundplatte und zumindest einem elektrischen Schaltelement zueinander passende Anschlüsse, z.B. Steckverbindungen ausgebildet werden und das zumindest eine elektrische Schaltelement durch einfachen Anschluss an die elektrische Verbindung an die Grundplatte angeschlossen ist.

Die genannten elektrischen Anschlüsse an der Grundplatte und/oder an dem elektrischen Schaltelement werden ebenfalls durch den 3D-Drucker ausgebildet, insbesondere im selben Arbeitsschritt, in dem auch der weitere Korpus der Grundplatte und/oder des Schaltelements ausgebildet wird.

Zumindest eines der Schaltelemente, vorzugsweise auch mehrere oder alle der Schaltelemente, die auf der Grundplatte angeordnet werden, werden durch den 3D-Drucker in einem dreidimensionalen Druckverfahren hergestellt, wobei auch ein leistungsübertragendes Schaltelement in 3D-Druck gefertigt ist.

Das Schaltelement wird als Verbundwerkstoffkörper aus mehreren Werkstoffen durch 3D-Druck ausgebildet, wobei hier zumindest ein signal- und/oder wärme- und/oder stromleitendes Material in gezielten Strukturen in ein nicht leitendes Matrixmaterial eingebettet werden kann. Beispielsweise kann eine Sicherung als 3D-Druck-Bauteil ausgebildet werden, bei dem ein Stromleiter in ein nicht leitendes Matrixmaterial eingebettet und Schicht für Schicht aufgebaut wird. Alternativ oder zusätzlich kann beispielsweise auch ein Piezo-Schalter im 3D-Druckverfahren hergestellt werden, bei dem ein sich unter Strombeaufschlagung verformendes Piezo-Element in entsprechender Weise Schicht für Schicht aufgebaut wird.

Gemäß der Erfindung sind die Grundplatte und das zumindest eine Schaltelement integral einstückig miteinander in einem 3D-Drucktechnik-Prozess schichtweise aufgebaut, sodass sozusagen das an der Grundplatte angebrachte Schaltelement Schicht für Schicht aus der Grundplatte herauswächst und/oder die Grundplatte Schicht für Schicht an das Schaltelement anwächst.

Die Verwendung der 3D-Drucktechnik erlaubt es, in die Grundplatte und/oder das jeweilige Schaltelement leitende Strukturen einzubringen, deren Erstreckung vom schichtweisen Aufbau des Matrixkorpus, in dem sie eingebettet ist, abweicht. Insbesondere können schräg zu den Schichtebenen verlaufende Leiter eingebracht werden, die sich nach Art eines elektrischen Leiters oder Kabels schlangenförmig auf und ab oder auch nur schräg ansteigend durch mehrere Matrixmaterial-Schichten hindurch erstrecken können. Anders als bei Laminiertechniken können signal- und/oder wärme- und/oder stromleitende Strukturen eingebracht werden, die sich in allen drei Dimensionen krümmen und/oder in ihrer Erstreckung verändern können.

Die Erfindung wird nachfolgend anhand eines Ausführungsbeispiels und einer zugehörigen Zeichnung näher erläutert, in denen zeigen:
- Fig. 1:: eine schematische, perspektivische Darstellung eines Schaltschranks mit darin aufgenommenen Schalttafeln, die jeweils mehrere auf einer Grundplatte angeordnete elektrische Schaltelemente umfassen, und
- Fig. 2:: eine Schnittansicht durch eine Grundplatte mit drei darauf angeordneten Schaltelementen, die die im Inneren der Grundplatte aufgenommenen Verbindungsleiter zwischen den Schaltelementen zeigt.

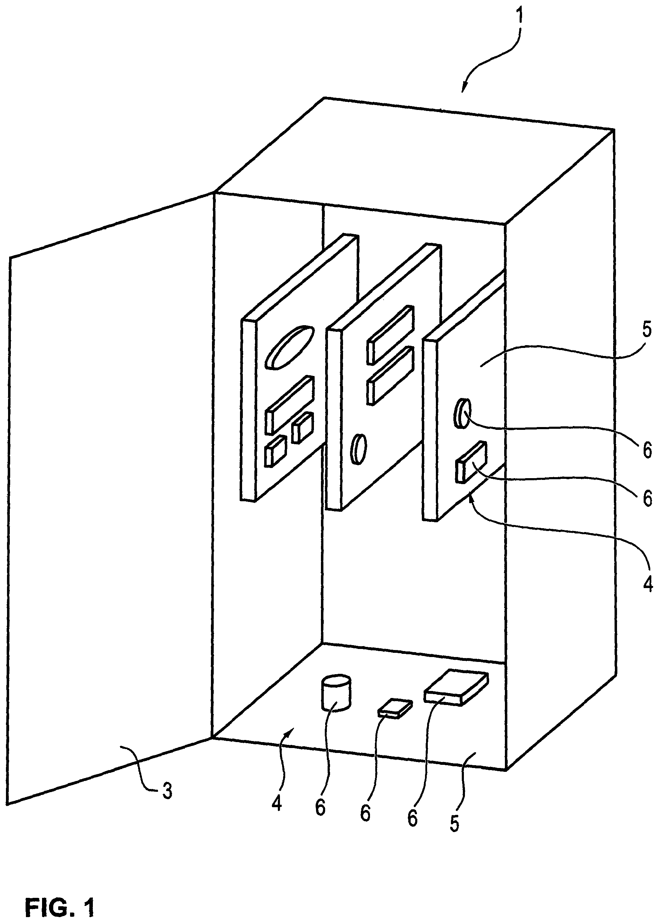

Wie Fig. 1 zeigt, kann der Schaltschrank 1 ein beispielsweise quaderförmiges Gehäuse 2 ggf. mit einer Tür 3 umfassen, in dem mehrere Schalttafeln 4 aufgenommen werden können, wobei die genannten Schalttafeln 4 horizontal oder vertikal im Inneren des Gehäuses 2 angeordnet werden können.

Die genannten Schalttafeln 4 umfassen jeweils eine Grundplatte 5, auf der mehrere Schaltelemente 6 angeordnet sind, wobei die genannten Schaltelemente 6 in der eingangs erwähnten Weise ausgebildet sein und verschiedene schalttechnische und/oder leistungselektronische Funktionen erfüllen können. Insbesondere können die genannten Schaltelemente 6 zusammen eine Schaltgerätekombination eines Hauptstromkreises bilden, der elektrische Leistung von einem Lieferanten wie beispielsweise einem Generator oder einem Netz erhält und auf einen oder mehrere Abnehmer beispielsweise in Form eines Motors überträgt und/oder verteilt. Die genannten Schaltelement 6 können also insbesondere auch leistungsübertragende Bauteile sein. Zusätzlich kann ein Teil der Schaltelemente 6 auch eine Schaltgerätekombination in einem Hilfsstromkreis bilden, der für die Steuerung, Messung, Meldung, Regelung und/oder Datenverarbeitung vorgesehen ist.

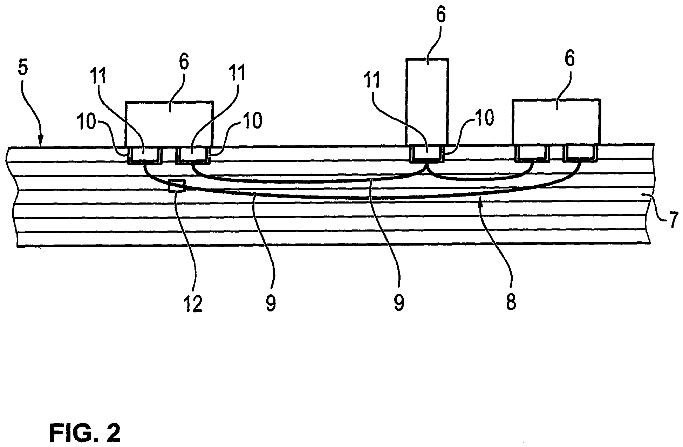

Wie Fig. 2 verdeutlicht, können die Grundplatten 5 in Schichtbauweise aufgebaut werden, und zwar mittels eines 3D-Druckers in 3D-Drucktechnik, wobei hier Schicht für Schicht ein oder mehrere Werkstoffe beispielsweise in Pulverform und/oder pastöser Form und/oder flüssiger Form aufgetragen und durch einen Energiestrahl wie beispielsweise einen Laserstrahl verflüssigt und/oder verfestigt und/oder gesintert und/oder in anderer Weise chemisch umgewandelt und/oder ausgehärtet werden können. Wie Fig. 2 zeigt, kann dabei in den nicht leitenden Matrixmaterialschichten 7 eine Schaltlogik 8 umfassend elektrische Verbindungsleiter 9 integriert bzw. eingebettet werden, wobei die genannte Schaltlogik 8 bzw. deren Verbindungsleiter 9 und ggf. weitere Schaltlogikelemente 12 wie Weichen und dergleichen aus einem signal- und/oder elektrischleitenden Material wie beispielsweise Kupfer im Zuge des 3D-Druckprozesses aufgebaut und eingebracht werden können, beispielsweise indem an den gewünschten Stellen der elektrischleitenden Struktur eine Kupferpulverspur gelegt und dann bei der Energiebeaufschlagung durch den Laserstrahl verschmolzen wird. Es kann also auch die Schaltlogik 8 bzw. deren Verbindungsleiter 9 Schicht für Schicht aufgebaut werden.

Vorteilhafter Weise werden dabei in die Grundplatte 5 ebenfalls mittels der 3D-Drucktechnik elektrische Anschlüsse 10 an einer Oberfläche der Grundplatte 5 ausgebildet und mit den Verbindungsleitern 9 verbunden ausgebildet, wobei die genannten elektrischen Anschlüsse 10 beispielsweise aus Steckbuchsen und/oder Steckervorsprüngen und/oder Klemmen bestehen können.

Die an der Grundplatte 5 anzubringenden Schaltelemente 6 können herkömmlicher Natur sein, vorteilhafter Weise aber ebenfalls zumindest teilweise mittels 3D-Drucktechnik hergestellt sein, wobei vorteilhafter Weise auch an den Schaltelementen 6 elektrische Anschlüsse 11 mittels 3D-Drucktechnik ausgebildet werden können. Die elektrischen Anschlüsse 10 der Grundplatte 5 und die elektrischen Anschlüsse 11 der Schaltelemente 6 sind dabei zueinander passend ausgebildet, sodass sie direkt miteinander verbunden werden können, um die Verbindung herzustellen. Vorteilhafter Weise können hierbei verschieden konturierte und/oder dimensionierte und/oder vom Lochbild her speziell konfigurierte Steck- oder Klemmenanschlüsse vorgesehen werden, sodass ein bestimmtes Schaltelement 6 nur an einer bestimmten Stelle in die Grundplatte gesteckt bzw. in einen bestimmten elektrischen Anschluss 10 der Grundplatte angeschlossen werden kann, sodass sich automatisch die richtige Verbindung und Schaltlogik ergibt. Werden auf beiden Grundplatten Klemmen angebracht, die dann anschließend mit Leitungen verbunden werden, ist es vorteilhaft, wenn die jeweiligen Klemmen so liegen, dass sie über parallel geführte Leitungen verbunden werden können, um mögliche Fehler in der Verdrahtung zu mininmieren.

Alternativ zu den genannten elektrischen Anschlüssen wäre es jedoch auch möglich, zumindest eines der Schaltelemente 6 integral einstückig mit der Grundplatte 5 im Zuge der 3D-Druckfertigung herzustellen.

Elektrische Anschlüsse können hierbei nicht nur zwischen den Schaltelementen 6 und der jeweiligen Grundplatte 5 vorgesehen werden, sondern es können auch alternativ oder zusätzlich hierzu entsprechende elektrische Anschlüsse zwischen mehreren Grundplatten 5 vorgesehen werden, sodass eine Schalttafel 4 aus mehreren Grundplatten zusammengestellt werden kann. Dabei ist es auch möglich, horizontal einzubauende Grundplatten 5 mit vertikal einzubauenden Grundplatten 5 zusammenzustellen.

## Patentansprüche

1. Verfahren zur Herstellung eines Schaltschranks (1), der zumindest eine Schalttafel (4) mit einer Grundplatte (5), auf der elektrische Schaltelemente zum Übertragen und/oder Verteilen elektrischer Energie an zumindest ein Betriebsmittel (6) angeordnet und miteinander elektrisch verbunden sind, einen Hauptstromkreis, der eine Schaltgerätekombination mit leistungselektronischen Bauteilen aus der Gruppe Stromrichter und Frequenzumrichter umfasst und dazu vorgesehen ist, von zumindest einem Lieferanten wie Generator oder Netz elektrische Leistung zu empfangen und an ein oder mehrere Betriebsmittel wie Motor zu übertragen, sowie einen Hilfsstromkreis, der eine eine Schaltlogik bildende Schaltgerätekombination umfasst und zumindest für die Steuerung des Hauptstromkreises vorgesehen ist, aufweist, **dadurch gekennzeichnet, dass** die zumindest eine Grundplatte (5), zumindest ein Schaltelement des Hilfsstromkreises und zumindest eines der leistungselektronischen Schaltelemente (6) des Hauptstromkreises mittels eines 3D-Druckers in einem 3D-Druckverfahren hergestellt wird, wobei die Grundplatte (5) als Verbundwerkstoffplatte aus verschiedenen Werkstoffen im 3D-Druckverfahren ausgebildet wird, wobei ein stromleitendes Material in Form gezielter Strukturen in ein nicht leitendes Matrixmaterial eingebettet wird, wobei die Schaltlogik des Hilfstromkreises in die Grundplatte integriert und mittels des 3D-Druckers beim Ausbilden der Grundplatte (5) mit ausgebildet wird, und wobei an der Grundplatte (5) sowie und an dem zumindest einen leistungselektronischen Schaltelement des Hauptstromkreises jeweils ein elektrischer Anschluss mittels des 3D-Druckers ausgebildet wird, und das zumindest eine leistungselektronische Schaltelement (6) durch Zusammenfügen der elektrischen Anschlüsse an die Grundplatte (5) angeschlossen wird.

2. Verfahren nach dem vorhergehenden Anspruch, wobei der Schaltschrank mehrere miteinander verbundene Grundplatten (5) enthält, wobei an den Grundplatten (5) zueinander passende elektrische Verbindungen mittels 3D-Druck ausgebildet werden und die Grundplatten (5) bei der Schaltschrankmontage zusammengefügt werden.

3. Verfahren nach einem der vorhergehenden Ansprüche, wobei die Grundplatte (5) zusammen mit zumindest einem darauf angeordneten Schaltelement (6) integral einstückig miteinander mittels des 3D-Druckers ausgebildet wird.

4. Verfahren nach einem der vorhergehenden Ansprüche, wobei zumindest eines der Schaltelemente (6) als Verbundwerkstoffkörper aus verschiedenen Werkstoffen durch 3D-Druck ausgebildet wird, wobei zumindest ein signal- und/oder wärme- und/oder stromleitendes Material in gezielten Strukturen in ein nicht leitendes Matrixmaterial eingebettet wird.

5. Verfahren nach einem der vorhergehenden Ansprüche, wobei zumindest eine mit der Grundplatte (5) zu verbindende Sicherung mittels des 3D-Druckers im 3D-Druckverfahren hergestellt wird.

6. Verfahren nach einem der vorhergehenden Ansprüche, wobei zumindest ein Teil eines Gehäuses des Schaltschranks mittels des 3D-Druckers in 3D-Drucktechnik hergestellt wird, wobei der genannte Teil des Gehäuses mittels 3D-Druck mit zumindest einer Halterung und/oder Führung zum Halten und/oder Führen der zumindest einen Grundplatte (5) versehen wird.

7. Verfahren nach einem der vorhergehenden Ansprüche, wobei die zumindest eine Grundplatte (5) und/oder zumindest eines der Schaltelemente (6) in Schichtbauweise Schicht für Schicht aufgebaut wird, wobei die Werkstoffschichten mittels Laserstrahl und/oder Elektronenstrahl und/oder Plasmastrahl verflüssigt und/oder verfestigt werden.

8. Schaltschrank umfassend zumindest eine Schalttafel (4) mit zumindest einer Grundplatte (5), auf der elektrische Schaltelemente (6) zum Übertragen und/oder Verteilen elektrischer Leistung angeordnet und miteinander elektrisch verbunden sind, einen Hauptstromkreis mit einer Schaltgerätekombination mit leistungselektronischen Schaltelementen aus der Gruppe Stromrichter und Frequenzumrichter umfasst, der zumindest teilweise als Schichtkörper ausgebildet ist, dessen Materialschichten einzeln Schicht für Schicht verfestigt sind und der dazu vorgesehen ist, elektrische Leistung von zumindest einem Lieferanten wie Generator oder Netz zu empfangen und an zumindest einen Abnehmer wie Motor oder Antrieb zu übertragen, und ferner zumindest einen Hilfsstromkreis mit einer Schaltgerätekombination umfasst, der zumindest teilweise als Schichtbaukörper ausgebildet ist, dessen Materialschichten einzeln Schicht für Schicht verfestigt sind und für die Steuerung des Hauptstromkreis vorgesehen ist, **dadurch gekennzeichnet, dass** die zumindest eine Grundplatte (5) einschließlich der in die Grundplatte integrierten Schaltlogik des Hilfsstromkreises und zumindest eines der leistungselektronischen Schaltelemente (6) des Hauptstromkreises jeweils als Schichtbaukörper ausgebildet ist, dessen Materialschichten einzeln Schicht für Schicht mittels eines 3D-Druckers im 3D-Druckverfahren verfestigt sind, wobei die Grundplatte und das zumindest eine leistungselektronische Schaltelement jeweils als Verbundwerkstoffkorpus aus verschiedenen Werkstoffen ausgebildet sind, wobei ein signal- und/oder stromleitendes Material in einer gezielten dreidimensionalen Struktur in ein nicht leitendes Matrixmaterial eingebettet ist, wobei die genannte dreidimensionale, leitende Struktur zumindest abschnittsweise einen Längsverlauf besitzt, der zu den Schichtebenen des Matrixmaterials spitzwinklig geneigt ist, und wobei an der Grundplatte (5) sowie und an dem zumindest einen leistungselektronischen Schaltelement des Hauptstromkreises jeweils ein elektrischer Anschluss ausgebildet und das zumindest eine leistungselektronische Schaltelement (6) durch Zusammenfügen der elektrischen Anschlüsse an die Grundplatte (5) angeschlossen ist.

## Claims

1. A method for manufacturing a switchgear cabinet (1), which has at least one switchboard (4) having a base plate (5), on which electrical switching elements for transmitting and/or distributing electrical energy to at least one piece of equipment (6) are arranged and electrically interconnected, a main circuit that comprises a switching device combination with power-electronics components from the group of power converters and frequency inverters and which is provided for receiving electrical power from at least one supplier such as a generator or network and for transmitting it to at least one consumer such as a motor, as well as an auxiliary circuit that comprises a switching device combination forming a switching logic and is at least provided for the control of the main circuit, **characterized in that** the at least one base plate (5), at least one switching element of the auxiliary circuit and at least one of the power electronics switching elements (6) of the main circuit is manufactured by means of a 3D printer using a 3D printing method, wherein the base plate (5) is formed as a composite material plate composed of different materials, using the 3D printing method, wherein a current-conducting material in the form of targeted structures is embedded in a non-conductive matrix material, wherein the switching logic of the auxiliary circuit is integrated into the base plate, wherein the said switching logic is formed by means of the 3D printer, while the base plate (5) is being formed, and wherein on the base plate (5) as well as on the at least one electrical connection is formed using the 3D printer in each case on the at least one power electronics switching element of the main circuit, and the at least one electrical switching element (6) is connected with the base plate (5) by joining the electrical connectors together.

2. The method according to one of the preceding claims, wherein the switchgear cabinet contains multiple base plates (5) that are connected with one another, wherein electrical connections that match one another are formed on the base plates (5), by means of 3D printing, and the base plates (5) are joined together during assembly of the switchgear cabinet.

3. The method according to one of the preceding claims, wherein the base plate (5) formed together with at least one switching element (6) arranged on it, integrally in one piece, by means of the 3D printer.

4. The method according to one of the preceding claims, wherein at least one of the switching elements (6) is formed as a composite material body, from different materials, by means of 3D printing, wherein at least one signal-conducting and/or heat-conducting and/or current-conducting material in targeted structures is embedded into a non-conductive matrix material.

5. The method according to one of the preceding claims, wherein at least one fuse to be connected with the base plate (5) is manufactured by means of the 3D printer, using the 3D printing method.

6. The method according to one of the preceding claims, wherein at least part of the housing of the switchgear cabinet is manufactured by means of the 3D printer, using 3D printing technology, wherein the said part of the housing is provided with at least one holder and/or guide for holding and/or guiding the at least one base plate (5), by means of 3D printing.

7. The method according to one of the preceding claims, wherein the at least one base plate (5) and/or at least one of the switching elements (6) is built up layer by layer, in a layered construction method, wherein the material layers are liquefied and/or solidified by means of a laser beam and/or electron beam and/or plasma beam.

8. A switchgear cabinet comprising at least one switchboard (4) having at least one base plate (5), on which electrical switching elements (6) for transmitting and/or distributing electrical power are arranged and electrically interconnected,
a main circuit that comprises a switching device combination with power-electronics components from the group of power converters and frequency inverters, which is at least partially formed as a layered structure, the material layers of which are solidified individually, layer by layer, and is provided for receiving electrical power from at least one supplier such as a generator or network and for transmitting it to at least one consumer such as a motor, as well as at least one auxiliary circuit that comprises a switching device combination, which is at least partially formed as a layered body, the material layers of which are solidified individually layer by layer and which is provided for the control of the main circuit, **characterized in that** the at least one base plate (5) including the switching logic integrated into the base plate and at least one of the power-electronic switching elements (6) of the main circuit is/are formed as a layered structure, the material layers of which are solidified individually, layer by layer by means of a 3D printer in a 3D printing method, wherein the base plate and the at least one power switching element are in each case formed as a composite material body from different materials, wherein a signal-conducting and/or heat-conducting and/or current-conducting material in a three-dimensional structure is embedded into a non-conductive matrix material, wherein the three-dimensional conductive structure possesses a longitudinal progression, at least in certain sections, which is inclined at an acute angle to the layer planes of the matrix material, and wherein an electrical connector is formed on the base plate (5) and on the at least one power switching element of the main circuit, and the at least one power electronics switching element (6) is connected with the base plate (5) by joining the electrical connectors together.

## Revendications

1. Procédé de fabrication d'une armoire de distribution (1), qui présente au moins un tableau de commutation (4) avec une plaque de base (5), sur laquelle des éléments de commutation électriques sont disposés aux fins du transfert et/ou de la distribution d'une énergie électrique à/au niveau d'au moins un moyen de fonctionnement (6) et sont reliés les uns aux autres de manière électrique, un circuit électrique principal, qui comprend une combinaison d'appareils de commutation avec des composants électroniques de puissance issus du groupe des convertisseurs et des convertisseurs de fréquence et qui est prévu pour recevoir d'au moins un fournisseur, tel un générateur ou un réseau, une puissance électrique et pour la transférer à un ou plusieurs moyens de fonctionnement, tels qu'un moteur, ainsi qu'un circuit électrique secondaire, qui comprend une combinaison d'appareils de commutation formant une logique de commutation et est prévu au moins pour la commande du circuit électrique principal, **caractérisé en ce que** l'au moins une plaque de base (5), au moins un élément de commutation du circuit électrique secondaire et au moins un des éléments de commutation (6) électroniques de puissance du circuit électrique principal sont fabriqués au moyen d'une imprimante 3D dans un procédé d'impression 3D, dans lequel la plaque de base (5) est réalisée en tant qu'une plaque en matériau composite à partir de différents matériaux dans le procédé d'impression 3D, dans lequel un matériau électroconducteur est incorporé sous la forme de structures ciblées dans un matériau de matrice non conducteur, dans lequel la logique de commutation du circuit électrique secondaire est intégrée dans la plaque de base et est réalisée au moyen de l'imprimante 3D lors de la réalisation de la plaque de base (5), et dans lequel respectivement un raccordement électrique est réalisé au moyen de l'imprimante 3D au niveau de l'au moins un élément de commutation électronique de puissance du circuit électrique principal, et l'au moins un élément de commutation (6) électronique de puissance est raccordé à la plaque de base (5) en regroupant les raccordements électriques.

2. Procédé selon la revendication précédente, dans lequel l'armoire de distribution contient plusieurs plaques de base (5) reliées les unes aux autres, dans lequel des lignes électriques s'adaptant les unes aux autres sont réalisées au moyen d'une impression 3D au niveau des plaques de base (5) et les plaques de base (5) sont regroupées lors du montage de l'armoire de distribution.

3. Procédé selon l'une quelconque des revendications précédentes, dans lequel la plaque de base (5) est réalisée conjointement avec au moins un élément de commutation (6) disposé dessus intégralement d'un seul tenant au moyen de l'imprimante 3D.

4. Procédé selon l'une quelconque des revendications précédentes, dans lequel au moins un des éléments de commutation (6) est réalisé en tant que corps en matériau composite à partir de différents matériaux par impression 3D, dans lequel au moins un matériau conducteur de signaux et/ou thermoconducteur et/ou électroconducteur est incorporé dans des structures ciblées dans un matériau de matrice non conducteur.

5. Procédé selon l'une quelconque des revendications précédentes, dans lequel au moins un fusible à relier à la plaque de base (5) est fabriqué au moyen de l'imprimante 3D dans le procédé d'impression 3D.

6. Procédé selon l'une quelconque des revendications précédentes, dans lequel au moins une partie d'un boîtier de l'armoire de distribution est fabriquée au moyen de l'imprimante 3D dans une technique d'impression 3D, dans lequel ladite partie du boîtier est pourvue d'au moins une fixation et/ou d'un guidage servant à maintenir et/ou à guider l'au moins une plaque de base (5) au moyen de l'impression 3D.

7. Procédé selon l'une quelconque des revendications précédentes, dans lequel l'au moins une plaque de base (5) et/ou au moins un des éléments de commutation (6) sont élaborés de manière stratifiée couche par couche, dans lequel les couches de matériau sont liquéfiées et/ou solidifiées au moyen d'un rayon laser et/ou d'un faisceau d'électrons et/ou d'un jet de plasma.

8. Armoire de distribution comprenant au moins un tableau de commutation (4) avec au moins une plaque de base (5), sur laquelle des éléments de commutation (6) électriques de transfert et/ou de distribution d'une puissance électrique sont disposés et sont reliés de manière électrique les uns aux autres, un circuit électrique principal avec une combinaison d'appareils de commutation avec des éléments de commutation électroniques de puissance issus du groupe des convertisseurs et des convertisseurs de fréquence, qui est réalisé au moins en partie en tant que corps stratifié, dont les couches de matériau sont solidifiées individuellement couche par couche et qui est prévu pour recevoir une puissance électrique d'au moins un fournisseur tel qu'un générateur ou un réseau et pour la transférer à au moins un collecteur tel qu'un moteur ou un entraînement, et en outre au moins un circuit électrique secondaire avec une combinaison d'appareils de commutation, qui est réalisé au moins en partie en tant que corps structurel stratifié, dont les couches de matériau sont solidifiées individuellement couche par couche et est prévu pour la commande d'un circuit électrique principal, **caractérisé en ce que** l'au moins une plaque de base (5), y compris la logique de commutation, intégrée dans la plaque de base, du circuit électrique auxiliaire et au moins un des éléments de commutation (6) électroniques de puissance du circuit électrique principal, est réalisée respectivement en tant que corps structurel stratifié, dont les couches de matériau sont solidifiées individuellement couche par couche au moyen d'une imprimante 3D dans le procédé d'impression 3D, dans lequel la plaque de base et l'au moins un élément de commutation électronique en puissance sont réalisés respectivement en tant que corps de matériau composite à partir de différents matériaux, dans lequel un matériau conducteur de signaux et/ou électroconducteur est incorporé dans un matériau de matrice non conducteur dans une structure tridimensionnelle ciblée, dans lequel ladite structure conductrice tridimensionnelle possède au moins par endroits un profil longitudinal, qui est incliné selon un angle aigu par rapport aux plans de couche du matériau de matrice, et dans lequel respectivement un raccordement électrique est réalisé au niveau de la plaque de base (5) ainsi qu'au niveau de l'au moins un élément de commutation électronique de puissance du courant électrique principal et l'au moins un élément de commutation (6) électronique de puissance est raccordé à la plaque de base (5) en regroupant les raccordements électriques.
